Europäisches Patentamt

European Patent Office

Office européen des brevets

Publication number: **0 292 092**
**A2**

# EUROPEAN PATENT APPLICATION

Application number: **88301960.6**

Int. Cl.⁴: **G06F 15/60**

Date of filing: **07.03.88**

Priority: **20.05.87 US 51567**

Date of publication of application:
**23.11.88 Bulletin 88/47**

Designated Contracting States:
**DE FR GB**

Applicant: **TEKTRONIX, INC.**
**Howard Vollum Park 14150 S.W. Karl Braun**
**Drive P.O. Box 500**
**Beaverton Oregon 97077(US)**

Inventor: **Rudwick, Thomas W., III**
**18310E N.W. Cornell Road**
**Beaverton Oregon 97006(US)**
Inventor: **Green, Daniel L.**
**11545 S.W. Settler Way**
**Beaverton Oregon 97005(US)**

Representative: **Wombwell, Francis et al**
**Potts, Kerr & Co. 15, Hamilton Square**
**Birkenhead Merseyside L41 6BR(GB)**

## Method of routing connections between terminals.

Connections between terminals on a carrier are routed using a program which involves resolving the surface of the carrier into a plurality of cells and forming five lists. A first list is formed of the connections that have yet to be routed and a second list is formed of the connections that have already been routed. All unmade connections are in the first list and all made connections are in the second list. A third list is formed of the cells that are not available for routing. The cells in the third list would include the cells that are occupied by functional blocks of the integrated circuit. The remaining cells are available for routing and are placed in a fourth list or a fifth list depending on whether or not they are occupied by connections in the second list. A connection from the first list is selected, and a determination is made as to whether the selected connection can be routed using only cells from the fifth list. If this can be done, the selected connection is removed from the first list and is placed in the second list and the cells used to route the connection are removed from the fifth list and placed in the fourth list. If the selected connection cannot be routed using only cells from the fifth list, a determination is made as to whether the connection can be routed using only cells from the fourth and fifth lists. If this can be done, the cells of the fourth list that are required to route the selected connection are identified and are removed from the fourth list and placed in the fifth list. Connections that occupy the identified cells are removed from the second list and are placed in the first list. The selected connection is removed from the first list and is placed in the second list, and the cells used to route the selected connection are removed from the fifth list and placed in the fourth list.

FIG.1

## METHOD OF ROUTING CONNECTIONS BETWEEN TERMINALS

This invention relates to a method of routing connections between terminals, and is particularly applicable to an automatic method for routing connections between functional blocks of an integrated circuit.

### Background of the Invention

The application of computer-aided design (CAD) to fabrication of an integrated circuit employing multiple functionally distinct circuit blocks, such as standard cells and gate arrays, has two major stages - system design and implementation. In the system design stage, the blocks that are to be used are selected and the connections that are required among the terminals of the blocks as defined. Data defining the shape and size of the die and various attributes of the blocks, including the shape and size of each block, the locations of terminals of the block, and the connections that are required among the terminals of the blocks, is specified to a CAD system. Implementation is concerned with using the CAD system to bring the product of the system design stage to practical application.

In order to maintain the volume of data to be stored and processed within manageable limits, the CAD system requires that all features that are defined in a plane parallel to the surface of the die be oriented along one or two orthogonal directions, normally referred to the horizontal or X direction and the vertical or Y direction. The CAD system resolves the area of the die into a matrix of identical rectangular, generally square, cells, and allows a given cell to contain only one feature.

Implementation itself has several phases. First, knowing the sizes and shapes of the blocks, a placement phase takes place. In the placement phase, a placement program acts on the data that has been provided to the CAD system to create data base files in which locations of the blocks on the integrated circuit die are defined such that there are no overlaps of blocks and economical use is made of the die area. Open spaces between blocks are reserved for channels to accommodate wiring connections among the terminals. After the placement phase is complete, a global routing phase takes place. The global routing program assigns the connections among the terminals to specific channels. The data base files are augmented with data reflecting these channel assignments. The precise route that a connection takes through a channel is thereafter defined in a detail routing phase, and the data base files are updated accordingly. In the detail routing phase, minor adjustments in the data defining the placement of the blocks might be made. At the end of the detail routing phase, the contents of the data base ɔs of the CAD system constitute a map of the integrated circuit die, representing the positions of the blocks on the die, the positions of the terminals of the blocks, and the routes followed by the connections among the terminals. These data base files are used when making the masks that are used in fabrication of the integrated circuit.

The success with which a CAD system may be used to aid in fabrication of an integrated circuit depends at a first level on being able to complete the design and this in turn depends upon the CAD system's being able to route all the connections that are defined in the system design stage within the channels that are defined in the placement phase.

At a second level, the success depends on being able to maximize the number of connections that can be completed automatically, without requiring human intervention.

The complexity of the integrated circuits that are currently being developed is such that a conventional detail routing program frequently is unable to complete a connection because the only connection paths that can be recognized by the program are blocked by connections that have previously been made. This occurs not because there is no possible path for completing the connection but because the routing program is unable to recognize the existence of a path. When the detail routing program is unable to complete a connection, the CAD system calls for human intervention to examine the problem and identify a suitable connection route. The more instances at which human intervention is required, the greater is the cost of completing the detail routing phase.

### Summary of the Invention

A preferred embodiment of the invention is a method of routing connections between terminals on a carrier having a predetermined peripheral boundary, the surface of the carrier being composed of a plurality of cells. A first list is formed of the connections that have yet to be routed and a second list is formed of the connections that have already been routed. All unmade connections are in the first list and all made connections are in the second list. If no routing has been done, all the connections are in the first list and none is in the second list. A third list is formed of the cells that are not available for routing. The cells in the third list would include the cells that are occupied by functional blocks of the integrated circuit. The remaining cells are available for routing and are placed in a fourth list or a fifth list depending on whether or not they are occupied by connections in the second list. A connection from the first list is selected, and a determination is made as to whether the selected connection can be routed using only cells from the fifth list. If this can be done, the selected connection is removed from the first list and is placed in the second list and the cells used to route the connection are removed from the fifth list and placed on the fourth list. If the selected connection cannot be routed using only cells from the fifth list, a determination is made as to whether the connection can be routed using only cells from the fourth and fifth lists. If this can be done, the cells of the fourth list that are required to route the selected connection are identified and are removed from the fourth list and placed on the fifth list. Connections that occupy the identified cells are removed from the second list and are placed in the first list. The selected connection is removed from the first list and is placed in the second list, and the cells used to route the selected connection are removed from the fifth list and placed in the fourth list.

## Brief Description of the Drawings

For a better understanding of the invention, and to show how the same may be carried into effect, reference will now be made, by way of example, to the accompanying drawings in which:

FIG. 1 is a block diagram of a CAD system,

FIG. 2 is a series of schematic plan views of a portion of a map depicting the surface of an integrated circuit die at various stages in routing connections over that surface, and

FIG. 3 is a similar series of views illustrating a cost map of the surface of the integrated circuit.

## Detailed Description

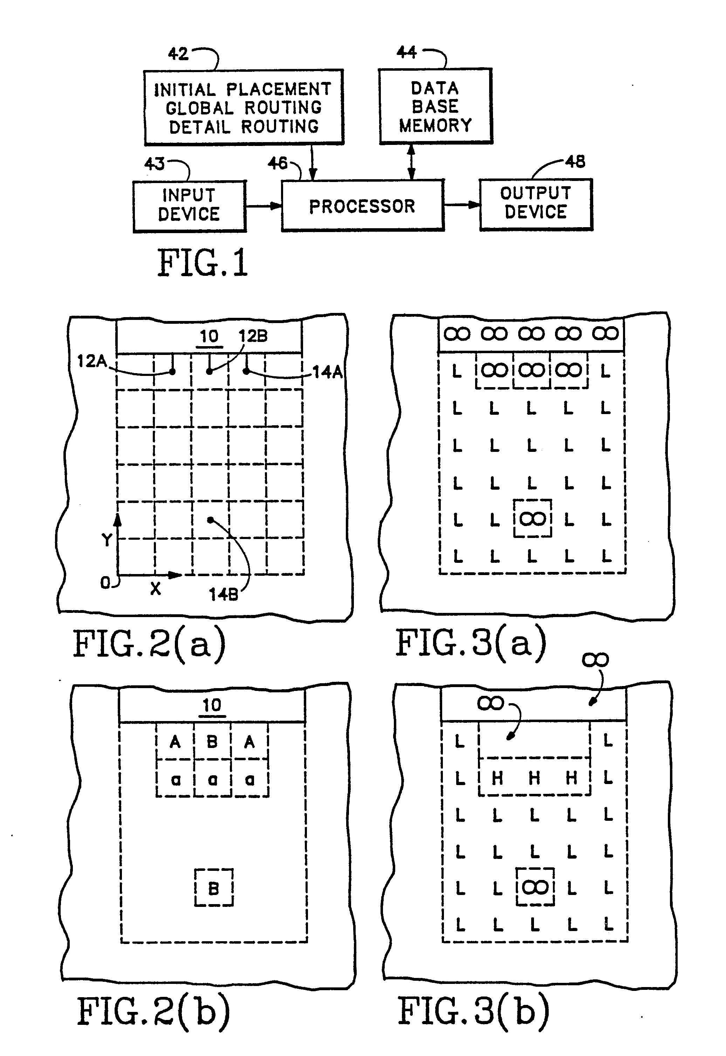

The CAD system illustrated in FIG. 1 comprises a program memory 42 in which the various programs required for using the CAD system to design an integrated circuit are stored. Information relating to the size and shape of the die, the size and shape of each functional block, the location of each terminal of each block and the connections that are made to each terminal is applied to the CAD system by way of an input device 43 and is stored in a random access memory 44. A processor 46 operates under control of the programs stored in the memory 42 to augment and update the data base files stored in the memory 44, and the contents of the memory 44 are made available by way of an output device 48.

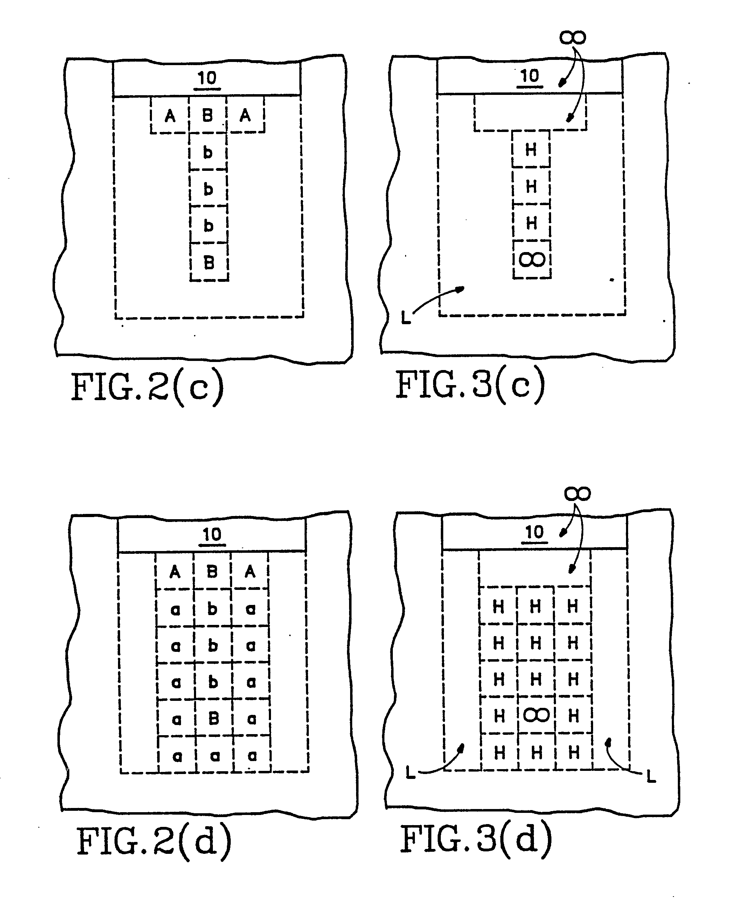

For the purpose of the following description, it will be assumed that the placement and global routing phases have been completed and that the detail routing phase has been started. The contents of the memory 44 represent a map of the surface of the die, with the functional blocks in position (subject to the possibility of minor adjustment) and with the connections between termi nals assigned to various channels between the blocks. FIG. 2(a) is a pictorial representation of a portion of the map. FIG. 2(a) illustrates a functional block 10 having two terminals 12A and 14A and a terminal 12B. FIG. 2-(a) also illustrates a via 14B. The positions of the block 10 and of the terminals 12 and 14 are defined in the memory 44 by reference to two orthogonal axes X and Y of a rectangular Cartesian coordinate system. The surface of the die is divided into a square array of cells, and the locations of elements on the surface of the die are defined by reference to the cells that they occupy. The terminals 12A, 12B and 14A and the via 14B are at positions (2,6), (3,6), (4,6) and (3,2) respectively relative to an origin O.

It will be assumed that the system design requires that the terminals 12A and 14A be interconnected and that the terminal 12B is to be connected to the via 14B.

The CAD system establishes five data base files that have particular relevance to the invention. The first file contains a list of the connections that have yet to be routed. The list of desired connections is loaded into this file. A second file contains a list of connections that have already been routed. Initially, this file is empty. A third file contains a list of cells that are not available for routing. These cells include the cells that are occupied by the functional blocks 10, the terminals 12A, 12B, and 14A, and the via 14B. Fourth and fifth files contain, respectively, a list of cells that are occupied by the connections identified in the second file, and a list of cells that are available for routing and are not occupied by connections in the second file. The third, fourth and fifth files effectively contain a cost map of the surface of the die. The cost map assigns a routing cost to each cell. The routing cost assigned to the cells listed in the third file is infinite ($\infty$), and the routing cost assigned to the cells listed in the fifth file is low (L). The routing cost assigned to the cells listed in the fourth file is high (H). The cost map corresponding to FIG. 2(a) is shown in FIG. 3(a).

It will be assumed for the purposes of the following description that the connection between the terminals 12A and 14A is selected for routing before the connection between the terminal 12B and the via 14B. The detail router examines the coordinates of the cells containing the terminals 12A and 14A, which are marked in FIG. 2(b) with the upper case letter A, and determines that the most direct route between these cells is not available because the cell containing the terminal 12B is in the third list and therefore is not available for routing. The next most direct route between the terminals 12A and 14A is through the cells (2,5), (3,5) and (4,5), which are marked in FIG. 2(b) with the lower case letter a. The first and second files are updated by transferring the connection (12A, 14A) from the first file to the second file, and the cells (2,5), (3,5) and (4,5) are transferred from the fifth file to the fourth file. The updated cost map is shown in FIG. 3(b).

Subsequently, the detail router selects the connection (12B, 14B) for completion. It can be seen by inspection of FIG. 2(b) that there is no route available for a connection between the cells marked B in FIG. 2(b), which contain the terminal 12B and the via 14B. Hitherto, it would have been necessary to call for human intervention in order to route the connection. However, the detail routing program is able to determine that the most direct path between the cells (3,2) and (3,6) lies through the cells (3,3), (3,4) and (3,5), and that none of these cells is listed in the third file. The router determines that only one cell [cell (3,5)] is listed in the fourth file. The router examines the cost map represented in FIG. 3(b) and determines that the cell (3,5) is included in the fourth file because it is in the connection route between the cells (2,6) and (4,6). The router therefore removes the connection (12A, 14A) from the second file and places it in the first file, and removes the cells (2,5), (3,5) and (4,5) from the fourth file and places them in the third file. In this manner, the connection (12A, 14A) is broken. At this point, the router places the connection between the terminal 12B and the via 14B in the second list and places the cells (3,3), (3,4) and (3,5) in the fourth file. See FIG. 2(c). The cells (3,3), (3,4) and (3,5) are marked b in FIG. 2(c). It is now necessary to re-establish the connection (12A, 14A). This is done by examining a progressively larger area of the map until an economical route is found. Of course, routes will be found that would involve breaking the connection (12B, 14B), but such routes are not selected because of the bias against breaking an existing connection that is provided by the high cost allocated to cells that are occupied by a connection. See FIG. 3(c).

A route of acceptable cost is found through the cells (2,5), (2,4), (2,3), (2,2), (2,1), 3,1), (4,1), (4,2), (4,3), (4,4) and (4,5). These cells are removed from the fifth file and placed in the fourth file, and the connection (12A, 14A) is placed in the second file. The updated maps are shown in FIGS. 2(d) and 3-(d).

In determining what connection path is to be followed, the router develops a cost metric which is given by the sum of the cost factor for all cells traversed by the route. In this manner, a route that is longer than other possible routes might be accepted because the cost of routing is less than that of shorter routes.

It will be appreciated that the present invention is not restricted to the particular embodiment that has been described, and that variations may be made therein without departing from the scope of the invention as defined in the appended claims and equivalents thereof. For example, the invention is not restricted to detail routing being performed using only the described detail routing program, since other detail routing programs might be run before (or after) the described program. Also, the five lists need not be stored in and represented by the contents of five distinct files. Some of the lists might exist only as RAM based data structures, contained only implicitly in an input or output file. In particular, the fifth list may be represented as all cells not identified as belonging to the third or fourth list.

## Claims

1. A method of creating a data base containing information defining the routes of connections between terminals, comprising the following steps, not necessarily in the order stated:

(a) defining the outer boundary of a space within which routing of connections must take place,

(b) defining a plurality of cells within the space defined by said outer boundary,

(c) establishing a first list of connections that have yet to be routed, a second list of connections that have already been routed, a third list of cells that are not available for routing, a fourth list of cells that are occupied by connections in the second list, and a fifth list of cells that are available for routing and are not occupied by connections in the second list,

(d) selecting a connection from the first list, and

(e) determining whether the selected connection can be routed using only cells from the fifth list and, if so,

(i) removing the selected connection from the first list and placing it in the second list and removing the cells used to route the selected connection from the fifth list and placing them in the fourth list, but if not

(ii) determining whether the selected connection can be routed using only cells from the fourth and fifth lists and, if so,

(A) identifying each cell of the fourth list that is needed to route the selected connection,

(B) removing the identified cell from the fourth list and placing it in the fifth list,

(C) removing the connection that occupies the cell identified in step (e)(ii)(A) from the second list and placing it in the first list,

(D) removing the selected connection from the first list and placing it in the second list, and

(E) removing the cells used to route the selected connection from the fifth list and placing them in the fourth list.

2. A method according to claim 1, further comprising:

(f) repeating steps (d) and (e), and

(g) repeating step (f) until there are no connections remaining in the first list.

3. A method according to claim 1, wherein step (e)(ii)(A) further comprises identifying the connection in the second list that occupies the identified cell and step (e)(ii)(B) further comprises removing all the cells occupied by the indentified connection from the fourth list and placing them in the fifth list.

4. An integrated circuit fabricated utilizing a design procedure comprising the following steps, not necessarily in the order stated:

(a) defining the outer boundary of a substrate,

(b) resolving the surface of the substrate into a plurality of cells,

(c) defining a placement of circuit blocks at preselected positions on the substrate, said circuit blocks having terminals,

(d) defining connections that are required between terminals of the circuit blocks, and

(e) routing the connections by

(i) establishing a first list of connections that have yet to be routed, a second list of connections that have already been routed, a third list of cells that are not available for routing, a fourth list of cells that are occupied by connections in the second list, and a fifth list of cells that are available for routing and are not occupied by connections in the second list,

(ii) selecting a connection from the first list, and

(iii) determining whether the selected connection can be routed using only cells from the fifth list and, if so,

(A) removing the selected connection from the first list and placing it in the second list and removing the cells used to route the connection from the fifth list and placing them in the fourth list, but if not

(B) determining whether the selected connection can be routed using only cells from the fourth and fifth lists and, if so,

(1) identifying each cell of the fourth list that is needed to route the selected connection,

(2) removing the identified cell from the fourth list and placing it in the fifth list,

(3) removing the connections that occupies the cell identified in step (e)(iii)(B)(1) from the second list and placing it in the first list,

(4) removing the selected connection from the first list and placing it in the second list, and

(5) removing the cells used to route the selected connection from the fifth list and placing them in the fourth list.

5. Apparatus for creating a data base containing information defining the routes of connections between terminals, comprising:

input means for receiving input data representing the outer boundary of a space within which routing of connections must take place, the locations of the terminals that are to be connected, and the connections that are required,

a first memory for storing said input data,

a second memory storing a routing program,

processor means for operating upon the input data stored in the first memory in accordance with the program stored in the second memory, and thereby modifying the input data, and

output means for providing the modified data,

wherein the program stored in the second memory is such as to cause the processor to execute the following operations,

(a) define a plurality of cells within the space defined by said outer boundary,

(b) establish a first list of connections that have yet to be routed, a second list of connections that have already been routed, a third list of cells that are not available for routing, a fourth list of cells that are occupied by connections in the second list, and a fifth list of cells that are available for routing and are not occupied by connections in the second list,

(c) select a connection from the first list, and

(d) determine whether the selected connection can be routed using only cells from the fifth list and, if so,

(i) remove the selected connection from the first list and place it in the second list and remove the cells used to rotate the selected connection from the fifth list and place them in the fourth list, but if not

(ii) determine whether the selected connections can be routed using only cells from the fourth and fifth lists and, if so,

(A) identify each cell of the fourth list that is needed to route the selected connection,

(B) remove the identified cell from the fourth list and place it in the fifth list,

(C) remove the connection that occupies the cell identified in step (d)(ii)(A) from the second list and place it in the first list,

(D) remove the selected connection from the first list and place it in the second list, and

(E) remove the cells used to route the selected connection from the fifth list and place them in the fourth list.

6. A method of creating a data base containing information defining the routes of connections between terminals, comprising the following steps, not necessarily in the order stated:

(a) defining the outer boundary of a space within which routing of connections must take place,

(b) defining a plurality of cells within the space defined by said outer boundary,

(c) establishing a first list of connections that have yet to be routed, a second list of connections that have already been routed, a third list of cells that are not available for routing, a fourth list of cells that are occupied by connections in the second list, and a fifth list of cells that are available for routing and are not occupied by connections in the second list,

(d) allocating a relatively high cost factor to cells in the fourth list and a relatively low cost factor to cells in the fifth list,

(e) selecting a connection from the first list, and

(f) selecting a route for the selected connection by

(i) identifying at least one possible route for the connection,

(ii) if only one route is identified, selecting that route, and if more than one route is identified, selecting the route for which the aggregate cost factor is a minimum,

(iii) identifying each cell of the fourth list that is needed to route the selected connection by the selected route,

(iv) removing the identified cell from the fourth list and placing it in the fifth list,

(v) removing the connection that occupies the identified cell from the first list and placing it in the second list, and

(vi) removing the cells used to route the selected connection from the fifth list and placing them in the fourth list.

FIG.1

FIG.2(a)

FIG.3(a)

FIG.2(b)

FIG.3(b)

FIG.2(c)

FIG.3(c)

FIG.2(d)

FIG.3(d)